**Europäisches Patentamt**

(19) **European Patent Office**

**Office européen des brevets**

(11) Veröffentlichungsnummer: **0 277 680**
**B1**

(12) **EUROPÄISCHE PATENTSCHRIFT**

(45) Veröffentlichungstag der Patentschrift: **06.02.91**

(51) Int. Cl.⁵: **C 23 C 16/44,** C 23 C 16/00

(21) Anmeldenummer: **88200106.8**

(22) Anmeldetag: **21.01.88**

(54) **Vorrichtung zum Anreichern eines Trägergases mit dem Dampf eines wenig flüchtigen Stoffes.**

(30) Priorität: **31.01.87 DE 3702923**

(43) Veröffentlichungstag der Anmeldung:
**10.08.88 Patentblatt 88/32**

(45) Bekanntmachung des Hinweises auf die
Patenterteilung:
**06.02.91 Patentblatt 91/06**

(84) Benannte Vertragsstaaten:
**DE FR GB NL**

(56) Entgegenhaltungen:
**DE-A-3 339 625**

(73) Patentinhaber: **Philips Patentverwaltung GmbH
Wendenstrasse 35 Postfach 10 51 49
D-2000 Hamburg 1 (DE)**
(84) **DE FR GB NL**

(73) Patentinhaber: **N.V. Philips'
Gloeilampenfabrieken
Groenewoudseweg 1
NL-5621 BA Eindhoven (NL)**
(84) **FR GB NL**

(72) Erfinder: **Gärtner, Georg, Dr.
Martelenberger Weg 16B
D-5100 Aachen (DE)**
Erfinder: **Rau, Hans, Dr.
Brunnenstrasse 11
D-5100 Aachen (DE)**
Erfinder: **Janiel, Peter
Otto-Dix-Strasse 1
D-5102 Würselen (DE)**

(74) Vertreter: **Piegler, Harald, Dipl.-Chem. et al
Philips Patentverwaltung GmbH Wendenstrasse
35 Postfach 10 51 49
D-2000 Hamburg 1 (DE)**

Courier Press, Leamington Spa, England.

**Beschreibung**

Die Erfindung betrifft eine Vorrichtung zum Anreichern eines Trägergases oder Trägergasgemisches mit dem Dampf oder den Dämpfen eines wenig flüchtigen, in Form kleiner fester Teilchen vorliegenden Stoffes oder Stoffgemisches, bestehend aus einem Gefäß, das einen herausnehmbaren, genau passenden Metallkörper enthält, wobei in mindestens eine Außenwandung des Metallkörpers eine gewundene Rille eingearbeitet ist und diese Außenwandung mit einer Innenwandung des Gefäßes derart in Berührung steht, daß die Rille einen beheizbaren Innenraum zur Aufnahme des Stoffes oder Stoffgemisches bildet, der mit einer Zuleitung für das Trägergas und einer Ableitung für das angereicherte Trägergas versehen ist, wobei die Leitungen derart in den Innenraum münden, daß das Trägergas bei Betrieb der Vorrichtung durch den Stoff oder das Stoffgemisch hindurchströmt.

Eine derartige Vorrichtung, bei der die Rille z.B. spiralförmig oder zickzackförmig oder mäanderförmig gewunden ist, ist aus DE-A-3 339 625 bekannt. Diese auch als Sättiger bezeichnete Vorrichtung dient der Einstellung eines definierten Gasstroms oder Massenflusses wenig flüchtiger Stoffe, die z.B. als Ausgangsverbindungen für eine chemische Abscheidung aus der Gasphase (CVD-Verfahren) eingesetzt werden. Als Beispiele für derartige Stoffe werden Verbindungen von IIIB-Metallen, insbesondere von Seltenerdmetallen und Thorium, insbesondere metallorganische Verbindungen, wie z.B. Thoriumacetylacetonat und Thoriumtrifluoracetylacetonat, genannt. Der Sättiger, der den wenig flüchtigen Stoff oder das wenig flüchtige Stoffgemisch in Pulverform enthält, weist einen langen Durchströmungsweg auf und läßt sich nach Benutzung einfach reinigen und wiederverwenden. Aus dem Sättiger tritt der beladene Trägergasstrom in eine Mischkammer und von dort in einen Reaktor ein, in dem die chemische Abscheidung aus der Gasphase stattfindet.

Der bekannte Sättiger hat den Nachteil, daß die einzelnen Windungen der Rille nicht dicht voneinander abgetrennt sind, wenn sich an den Auflagestellen, an denen die Außenwandung des Metallkörpers und die Innenwandung des Gefäßes miteinander in Berührung stehen, Pulver-Restschichten befinden, so daß Querströmungen bzw. Abkürzungen des Trägergasstromes auftreten können, die die Wirksamkeit des Sättigers herabsetzen. Ein weiteres Querleck für das Trägergas kann durch die Einpassung des Metallkörpers, z.B. eines Kupferblocks, in das Gefäß entstehen, wenn der Metallkörper nicht dicht aufgepreßt ist.

Außerdem zeigt der bekannte Sättiger bereits dann eine starke Abnahme seiner Wirksamkeit und des Massenflusses an wenig flüchtigem Stoff, wenn an sich noch mengenmäßig ausreichend viel Stoff zur Verdampfung und zum Transport zum CVD-Reaktor vorhanden ist. Dies liegt daran, daß die Pulverschüttung in den Rillen sich bei zunehmendem Verbrauch langsam erschöpft, in sich zusammensinkt und das Trägergas über die Oberfläche der Schüttung hinwegstreicht, ohne daß eine ausreichende Sättigung erzielt wird, insbesondere dann, wenn der eingefüllte Stoff einen sehr niedrigen Verdampfungskoeffizienten hat. Außerdem treten bei einigen metallorganischen Verbindungen bei Erhöhung der Temperatur Phasenübergänge auf, die mit Änderungen der Dichte verbunden sind.

Die Erfindung hat die Aufgabe, einen Sättiger zu schaffen, bei dessen Betrieb das Trägergas durch den Stoff oder das Stoffgemisch strömt, ohne eine Ausweichmöglichkeit zu haben, und mit dem ein für die chemische Abscheidung aus der Gasphase insbesondere bei niedrigen Drükken im Sättiger (z.B. 1 bis 100 hPa) ausreichend großer und konstanter Massenfluß dieses Stoffes über längere Abscheidungsdauern erzielt wird.

Diese Aufgabe wird erfindungsgemäß dadurch gelöst, daß bei einer Vorrichtung der eingangs genannten Art die zwischen den einzelnen Windungen der Rille liegenden Teile der Außenwandung des Metallkörpers, die mit der Innenwandung des Gefäßes in Berührung stehen und die einzelnen Windungen der Rille voneinander trennen, ein Querschnittsprofil in Form eines Keils aufweisen, dessen Spitze mit der Innenwandung des Gefäßes in Berührung steht.

Aus dem keilförmigen Querschnittsprofil ergibt sich, daß die zwischen den einzelnen Windungen der Rille liegenden Teile die Form einer Schnittkante haben.

Eine alternative Ausführungsform der Erfindung besteht darin, daß die Rille in den Boden des Gefäßes eingearbeitet ist, während die Unterseite des Metallkörpers glatt ausgebildet ist, wobei die Teile des Gefäßbodens, die die einzelnen Windungen der Rille voneinander trennen, ein Querschnittsprofil in Form eines Keils aufweisen, dessen Spitze mit der Unterseite des Metallkörpers in Berührung steht. Diese Ausführungsform hat den Vorteil, daß die Rille sich einfacher füllen läßt.

Die Rille ist also entweder in eine Außenwandung des Metallkörpers, z.B. in dessen Unterseite, oder in den Boden des Gefäßes eingearbeitet. Die zwischen den einzelnen Windungen liegenden Teile weisen ein Querschnittsprofil in Form eines Keils auf, dessen Spitze entweder mit der glatt ausgebildeten Innenwandung des Gefäßes oder mit der glatt ausgebildeten Unterseite des Metallkörpers in Berührung steht.

Bei beiden Ausführungsformen ist es zweckmäßig, daß das Material des Teils, das den keilförmigen Querschnitt aufweist, härter als das Material des Teils ist, mit dem die Oberkante des Teils mit keilförmigem Querschnitt in Berührung steht. Beispielsweise besteht bei der ersten Ausführungsform der Metallkörper aus Edelstahl und die Innenwandung des Gefäßes aus Kupfer, während bei der zweiten Ausführungsform der Boden des Gefäßes aus Edelstahl und der Metallkörper aus Kupfer besteht. Dadurch wird erreicht, daß die Oberkante des Teils mit dem keilförmigen Querschnitt beim Zusammenbau der Vorrichtung ein wenig in den weicheren Teil eindringt oder einschneidet, was zu einer ausgezeichneten Gasabdichtung führt.

Dabei ist es aber nicht notwendig, daß die Oberkante und die übrige Oberfläche der Rille aus dem gleichen Material bestehen. Es ist z.B. vorteilhaft, nur die Oberkante des Teils mit keilförmigem Querschnitt mit einem Hartstoff wie Titannitrid oder Titancarbid z.B. per CVD zu überziehen.

Im Querschnittsprofil der Rillenkanten schließen die Flanken des Keils einen Winkel zwischen 40° und 140°, vorzugsweise zwischen 60° und 90°, ein. Dabei können die beiden Flanken des Keils auch unterschiedlich geneigt sein. In jedem Falle wird eine dichte Quer-Abtrennung zwischen den einzelnen Windungen der Rille erreicht.

Die zuvor erwähnte Schnittkante kann eine scharfe Schnittkante sein, d.h. die Kante zwischen den die Rille begrenzenden Oberflächen ist in diesem Fall im Querschnitt eine gekrümmte Linie mit mikroskopisch kleinem Krümmungsradius. Es wurde jedoch gefunden, daß ein abgerundetes Profil in den meisten Fällen, z.B. bei grobkörnigen Pulvern, genauso gut wirkt und den zusätzlichen Vorteil hat, sich noch leichter reinigen zu lassen, ohne daß scharfe Kanten sich störend bemerkbar machen.

Aus dem keilförmigen Querschnittsprofil ergibt sich ferner, daß die Rille in ihrer einfachsten Form einen V-förmigen Querschnitt aufweist. Zur Erzielung eines hohen Wirkungsgrades des Sättigers und einer dichten Quer-Abtrennung zwischen den einzelnen Windungen der Rille sind jedoch andere Querschnittsprofile der Rille mindestens genauso vorteilhaft. Zum Zwecke einer besseren Reinigung der Rille ist es sogar von Vorteil, das Profil in der Tiefe der Rille flach oder rund vertieft auszuführen. Derartige Rillen weisen einen rinnenförmig eingewölbten oder einen wannenförmigen Querschnitt auf. Für die Form des Rillenquerschnittsprofils ist es nur wesentlich, daß es stetig ist und im Bereich zwischen Kante und Rillenmitte ein monoton (im mathematischen Sinne) fallender Kurvenzug bzw. Polygonzug ist.

Der Krümmungsradius $r_K$ der zuvor erwähnten abgerundeten Spitze des Keils ist in aller Regel wesentlich kleiner als der Krümmungsradius $r_B$ der rinnenförmigen Wölbung, z.B. gilt $r_K < 1/3 \, r_B$, damit eine noch funktionierende Abdichtung erreicht wird. Auch hier ist es von Vorteil, das Material der Auflagerundung härter als das Material des aufgepreßten Metallkörpers zu wählen.

Das Gefäß wird mit pulverförmigem, wenig flüchtigem Stoff gefüllt, der zur mechanischen Stabilisierung und möglichst feinen Verteilung vorzugweise mit einem grobkörnigeren inerten Material, z.B. Quarzpulver im Verhältnis 1 : 2, vermischt ist. Bei der zweiten Ausführungsform wird die Rille mit einem Pulvergemisch, z.B. aus einer metallorganischen Verbindung und Quarzpulver, randvoll gefüllt.

Danach wird ein passender Metallkörper, z.B. ein Kupferblock, auf den Gefäßboden aufgepreßt, z.B. mit einem Bajonettverschluß. Eine zusätzliche Außenabdichtung des Innenraums wird gegebenenfalls durch eine zwischen dem Metallkörper und dem Gefäß eingefügte Dichtung, z.B. aus Fluorelastomer oder Gold, erreicht.

Zur Beheizung wird das Gefäß in einem thermostatisierten Flüssigkeitsbad, z.B. in einem Ölbad, angeordnet. Die Beheizung der Vorrichtung kann aber auch elektrisch erfolgen. Zusätzlich können an der Gaszuleitung und der Gasableitung ausheizbare Auf/Zu-Ventile vorgesehen werden. Dabei ist es zweckmäßig, daß in der Gaszuleitung nach dem Ventil und in der Gasableitung vor dem Ventil jeweils ein Pulverrückhaltefilter angeordnet ist, das nur einen sehr geringen Druckabfall verursacht.

Wie bereits erwähnt, nimmt die Masse des eingefüllten wenig flüchtigen Stoffes mit andauerndem Trägergasfluß kontinuierlich ab, so daß die Füllhöhe in dem von der Rille gebildeten Innenraum im Laufe der Zeit abnimmt und das Trägergas wegen des geringeren Strömungswiderstandes vor allem durch den über der Oberfläche des restlichen wenig flüchtigen Stoffes entstehenden Zwischenraum strömt und der Sättigungsdruck abnimmt. Dabei nimmt der Sättigungsdruck um so stärker ab, je niedriger der Verdampfungskoeffizient des wenig flüchtigen Stoffes ist. Ein konstanter Massenfluß der Ausgangsverbindung für das CVD-Verfahren kann dann nicht mehr aufrechterhalten werden.

Dieser Nachteil wird vorzugsweise dadurch beseitigt, daß das gefüllte Gefäß derart in dem Flüssigkeitsbad angeordnet ist, daß der Boden des Gefäßes parallel zur Schwerkraftrichtung steht, und das Trägergas bei Betrieb der Vorrichtung von oben durch den Stoff oder das Stoffgemisch hindurchströmt.

Der Sättiger wird also nach dem Füllen und Verschließen um 90° verkippt, und zwar so, daß der Boden des Gefäßes und die Unterseite des Metallkörpers parallel zur Schwerkraftrichtung stehen, wobei der Trägergaseintritt von oben erfolgt. Durch diese Verkippung wird erreicht, daß die entstehenden Hohlräume in den Windungen der Rille sich nur in dem nunmehr oben liegenden Teil des Sättigers ausbilden, weil das restliche Pulver sich durch die Schwerkraft im nunmehr unten liegenden Teil des Sättigers sammelt. Dadurch wird das Trägergas gezwungen, ohne die Möglichkeit einer Gangbildung feinverteilt durch das restliche Pulver hindurchzuströmen. Bei diesem vertikalen Betrieb verschlechtert sich die Wirksamkeit des Sättigers praktisch nicht, solange noch mehr als 1/4 der Ausgangsmenge vorhanden ist.

Falls man gezwungen ist, die horizontale Lage des Sättigers nach dem Füllen beizubehalten, weil aus konstruktiven Gründen keine Verkippungsmöglichkeit vorgesehen werden kann, so wird die Hohlraum- und Gangbildung nach einer weiteren Ausgestaltung der Erfindung durch eine Druckkammer verhindert, die von dem durch die Rille gebildeten Innenraum durch eine biegsame Membran getrennt ist.

Die Druckkammer wird vorzugsweise dadurch gebildet, daß der gewundenen Rille eine zweite gewundene Rille gegenüberliegt, die in den Boden des Gefäßes oder in die Unterseite des Metallkörpers eingearbeitet ist (also dort, wo bisher noch keine Rille war) und die durch die Membran von der ersten Rille getrennt ist, wobei der von der zweiten Rille und der Membran umschlossene Raum, d.h. die Druckkammer, an eine Druckgasleitung angeschlossen ist.

Bei einer weiteren Ausgestaltung der Erfindung sind in die Außenwandung des Metallkörpers oder in den Boden des Gefäßes statt einer einzigen Rille mehrere parallel verlaufende Rillen eingearbeitet. Durch ein Einarbeiten von z.B. 10 parallelen Rillen statt einer einzigen Rille wird der Strömungsquerschnitt um einen Faktor 10 erhöht, die Strömungsgeschwindigkeit wird langsamer, der Sättigungs-Wirkungsgrad wird verbessert (bzw. bleibt optimal), die Beschickungsmenge des CVD-Reaktors wird erhöht und die Nutzungsdauer wird länger.

Der erfindungsgemäße Sättiger hat den Vorteil, das Gaszuleitung und -ableitung gegeneinander abgedichtet sind, daß die Füllmenge an Stoff genau vorgegeben ist und daß bei Einfüllung bis zur Höhe der Oberkanten der Teile zwischen den einzelnen Windungen der Rille keine Über- oder Unterfüllung auftreten kann. Weiterhin werden auf dem langen, spiralförmigen Durchströmungsweg, der z.B. 70 bis 100 cm lang ist, auch wenig flüchtige Stoffe mit sehr niedrigen Verdampfungskoeffizienten im Trägergas angereichert. Außerdem wird durch ein Einschneiden der besagten Kanten in den Metallkörper eine Querströmung des Trägergases vermieden, die sonst den Wirkungsgrad des Sättigers herabsetzen würde.

Die Erfindung wird anhand einiger Ausführungsbeispiele näher erläutert, die in einer Zeichnung dargestellt sind. In der Zeichnung zeigen

Fig. 1 einen Sättiger schematisch im Schnitt,

Fig. 2a bis 2d Querschnittsprofile von Rillen,

Fig. 3 einen Teil eines Sättigers mit Druckkammer im Schnitt und

Fig. 4 einen Teil eines Sättigers mit mehreren parallelen Rillen in Draufsicht.

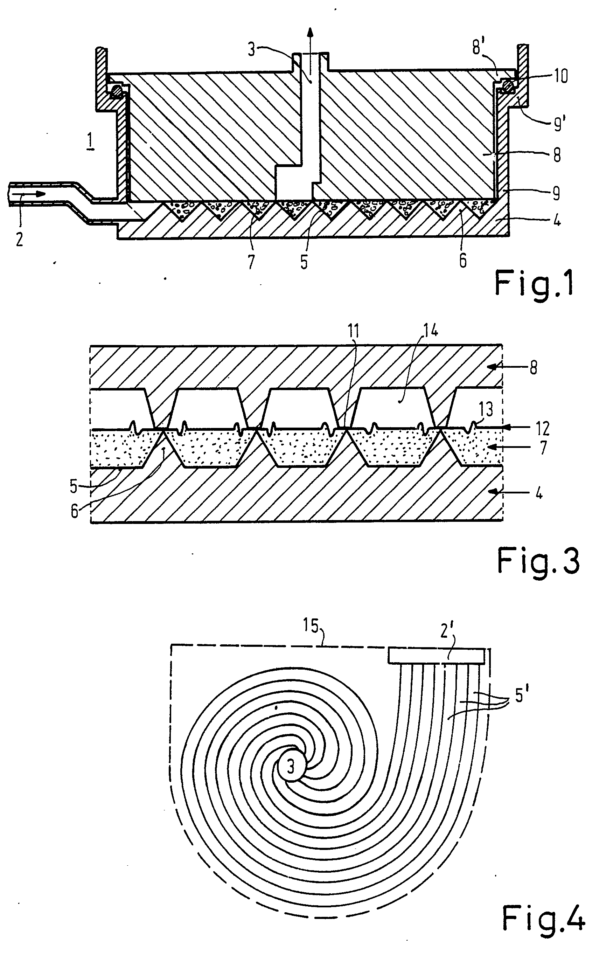

Der in Fig. 1 dargestellte Sättiger besteht aus einem Gefäß 1, z.B. aus Edelstahl, mit einer Trägergaszuleitung 2 und einer Trägergasableitung 3 mit je einem Gaseinlaß- und Gasauslaßventil und einem Durchflußmengenregler für das Trägergas (nicht dargestellt). Weiterhin sind in der Gaszuleitung 2 und in der Gasableitung 3 je ein dünnes feines Sieb oder/und ein Stück Aluminiumoxid-Wolle angeordnet (nicht dargestellt), die zur Rückhaltung des eingefüllten Pulvers (siehe weiter unten) dienen. Der Boden 4 des Gefäßes ist mit einer Spiralrille 5 mit V-förmigem Querschnitt versehen. Die einzelnen Windungen der Rille 5 sind durch Teile 6 mit keilförmigem Querschnitt voneinander getrennt. In die Spiralrille 5 ist ein pulverförmiger, wenig flüchtiger Stoff 7 eingefüllt. Der Stoff ist gegebenenfalls mit Quarzpulver vermischt. Ein Metallkörper 8, z.B. ein Einsatzblock aus Kupfer, ist auf die Spitzen bzw. Kanten der Teile 6 aufgepreßt, z.B. durch einen (nicht dargestellten) Bajonett-Verschlußring oder durch Verschraubung mit einem in die Gefäßwand 9 eingeschnittenen Gewinde. Die Abdichtung des Innenraums erfolgt durch einen zwischen einer Auflagestufe 8' des Metallkörpers 8 und einer Auflagestufe 9' der Gefäßwand 9 eingefügten Dichtungsring 10, z.B. aus Fluorelastomer oder aus Gold. Die Beheizung des Sättigers erfolgt durch Eintauchen in ein thermostatisiertes Ölbad (nicht dargestellt).

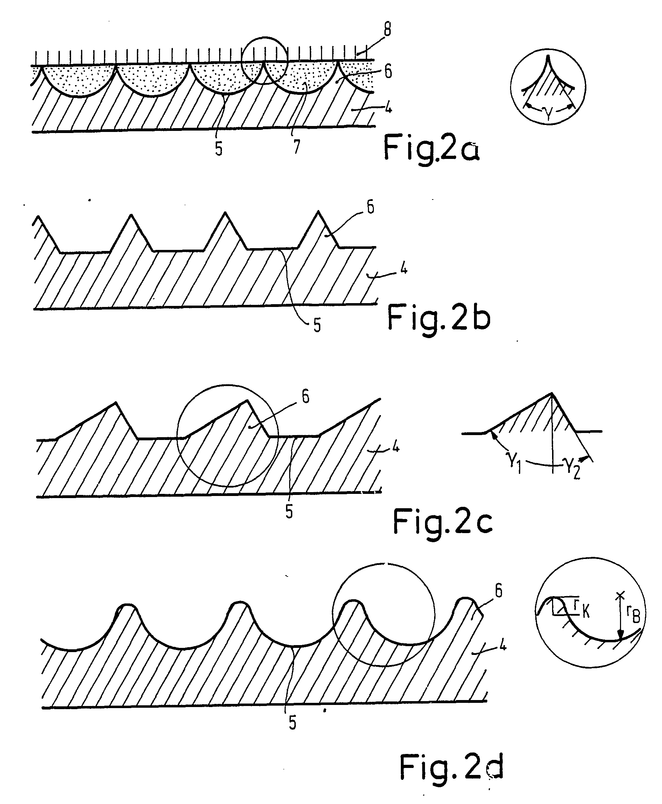

Die Fig. 2a bis 2d zeigen unterschiedliche in den Boden 4 des Gefäßes eingearbeitete Rillenprofile. Fig. 2a zeigt ein rinnenförmig eingewölbtes Profil, die Fig. 2b und 2c zeigen wannenförmige Profile. In vergrößerten Ausschnitten aus den Fig. 2a und 2c sind Winkel $\gamma$, $\gamma 1$ und $\gamma 2$ dargestellt, die die Flanken des Keils 6 einschließen. Fig. 2c zeigt, in welcher Weise die beiden Flanken des Keils unterschiedlich geneigt sind ($\gamma 1 > \gamma 2$), wodurch eine bessere Abdichtung mit dem aufgepreßten Metallkörper bei Temperaturzyklen mit großen Änderungen erreicht wird. Nach Fig. 2d ist die Spitze des Keils 6 abgerundet; in einem vergrößerten Ausschnitt sind der Krümmungsradius $r_K$ der abgerundeten Spitze und der Krümmungsradius $r_B$ der rinnenförmigen Wölbung dargestellt.

In Fig. 3 bezeichnet 4 wiederum den Boden des Gefäßes mit der Rille 5 und den Teilen 6 mit keilförmigem Querschnitt. 7 ist die Sättigerfüllung, 8 bezeichnet den Metallkörper und 11 die Gegenauflageflächen für die Oberkanten der Teile 6 mit keilförmigem Querschnitt. Zwischen dem Gefäßboden 4 und dem Metallkörper 8 bzw. der Oberkante der Teile 6 und der Gegenauflagefläche 11 ist eine biegsame Membran 12, z.B. aus Tantalblech, eingelegt, in die zusätzlich noch Dehnungsrillen 13 eingepreßt sind, um eine günstige Verformung erzielen zu können. Nach Füllen und Verschließen des Sättigers liegt die Membran glatt aufgepreßt auf der Füllung 7 auf. Mit zunehmendem Abtransport von wenig flüchtigem Stoff sinkt die Füllung, d.h. die Pulverschüttung, etwas in sich zusammen. Durch die Beschickung einer passend zum Gefäßboden verlaufenden, d.h. ebenfalls spiralförmig gewundenen, Druckkammer 14 mit einem Gas höherem Druckes (zweckmäßigerweise ein Inertgas, das mit dem Trägergas identisch sein kann) als dem Druck in der Füllung 7 kann nun die Membran wiederum dicht auf die Oberfläche der Füllung aufgepreßt werden, so daß ein Spalt zwischen Rillenabschluß und Füllungsoberfläche nicht entsteht. In vielen Fällen genügt es auch, die Druckkammer 14 unter normalem Atmosphärendruck zu lassen, so daß die Membran bei dem in der Regel sehr niedrigen Druck innerhalb der Rille (<100 hPa) automatisch auf die Füllung aufgepreßt wird.

In Fig. 4 bezeichnen 2' eine mit der Trägergaszuleitung (nicht dargestellt) verbundene Gaseintrittskammer, 5' mehrere parallel verlaufende Rillen und 3 eine Trägergasableitung. Die Berandung 15 des die Rillen aufnehmenden Bauteils kann halbkreisförmig, aber auch rechteckig oder kreisrund sein. Im letzten Fall ist die Eintrittskammer 2' auf der kreisrunden Berandungsseite angeordnet. Das Spiralzentrum, d.h. die Trägergasableitung, und der Kreismittelpunkt sind nicht identisch. Auch bei dieser Vorrichtung kann eine Verkippung um 90° erfolgen.

## Patentansprüche

· 1. Vorrichtung zum Anreichern eines Trägergases oder Trägergasgemisches mit dem Dampf oder den Dämpfen eines wenig flüchtigen, in Form kleiner fester Teilchen vorliegenden Stoffes oder Stoffgemisches, bestehend aus einem Gefäß, das einen herausnehmbaren, genau passenden Metallkörper enthält, wobei in mindestens einer Außenwandung des Metallkörpers eine gewundene Rille eingearbeitet ist und diese Außenwandung mit einer Innenwandung des Gefäßes derart in Berührung steht, daß die Rille einen beheizbaren Innenraum zur Aufnahme des Stoffes oder Stoffgemisches bildet, der mit einer Zuleitung für das Trägergas und einer Ableitung für das angereicherte Trägergas versehen ist, wobei die Leitungen derart in den Innenraum münden, daß das Trägergas bei Betrieb der Vorrichtung durch den Stoff oder das Stoffgemisch hindurchströmt, dadurch gekennzeichnet, daß die zwischen den einzelnen Windungen der Rille liegenden Teile der Außenwandung des Metallkörpers, die mit der Innenwandung des Gefäßes in Berührung stehen und die einzelnen Windungen der Rille voneinander trennen, ein Querschnittsprofil in Form eines Keils aufweisen, dessen Spitze mit der Innenwandung des Gefäßes in Berührung steht.

2. Abwandlung der Vorrichtung nach Anspruch 1, dadurch gekennzeichnet, daß die Rille (5) in den Boden (4) des Gefäßes (1) eingearbeitet ist, während die Unterseite des Metallkörpers (8) glatt ausgebildet ist, wobei die Teile (6) des Gefäßbodens (4), die die einzelnen Windungen der Rille (5) voneinander trennen, ein Querschnittsprofil in Form eines Keils aufweisen, dessen Spitze mit der Unterseite des Metallkörpers (8) in Berührung steht.

3. Vorrichtung nach Anspruch 1 oder 2, dadurch gekennzeichnet, daß das Material des Teils, das den keilförmigen Querschnitt aufweist, härter als das Material des Teils ist, mit dem die Oberkante des Teils mit keilförmigem Querschnitt in Berührung steht.

4. Vorrichtung nach Anspruch 3, dadurch gekennzeichnet, daß die Oberkante des Teils mit keilförmigem Querschnitt mit einem Hartstoff überzogen ist.

5. Vorrichtung nach Anspruch 1 oder 2, dadurch gekennzeichnet, daß die Flanken des Keils einen Winkel zwischen 40° und 140° einschließen.

6. Vorrichtung nach Anspruch 5, dadurch gekennzeichnet, daß die Flanken des Keils einen Winkel zwischen 60° und 90° einschließen.

7. Vorrichtung nach Anspruch 5, dadurch gekennzeichnet, daß die beiden Flanken des Keils unterschiedlich geneigt sind.

8. Vorrichtung nach Anspruch 5, dadurch gekennzeichnet, daß die Spitze des Keils abgerundet ist.

9. Vorrichtung nach Anspruch 1 oder 2, dadurch gekennzeichnet, daß die Rille (5) einen V-förmigen Querschnitt aufweist.

10. Vorrichtung nach Anspruch 1 oder 2, dadurch gekennzeichnet, daß die Rille (5) einen rinnenförmig eingewölbten Querschnitt aufweist.

11. Vorrichtung nach Anspruch 1 oder 2, dadurch gekennzeichnet, daß die Rille (5) einen wannenförmigen Querschnitt aufweist.

12. Vorrichtung nach Anspruch 1 oder 2, dadurch gekennzeichnet, daß im Betrieb das Gefäß (1) in einem thermostatisierten Flüssigkeitsbad angeordnet ist.

13. Vorrichtung nach Anspruch 1 oder 2, dadurch gekennzeichnet, daß an der Gaszuleitung (2) und der Gasableitung (3) ausheizbare Auf/Zu-Ventile vorgesehen sind.

14. Vorrichtung nach Anspruch 14, dadurch gekennzeichnet, daß in der Gaszuleitung (2) nach dem Ventil und in der Gasableitung (3) vor dem Ventil jeweils ein Pulverrückhaltefilter angeordnet ist.

15. Vorrichtung nach Anspruch 13, dadurch gekennzeichnet, daß das gefüllte Gefäß (1) derart in dem Flüssigkeitsbad angeordnet ist, daß der Boden (4) des Gefäßes (1) parallel zur Schwerkraftrichtung steht, und das Trägergas bei Betrieb der Vorrichtung von oben durch den Stoff oder das Stoffgemisch (7) hindurchströmt.

16. Vorrichtung nach Anspruch 1 oder 2, gekennzeichnet durch eine Druckkammer (14), die von dem durch die Rille (5) gebildeten Innenraum durch eine biegsame Membran (12) getrennt ist.

17. Vorrichtung nach Anspruch 17, dadurch gekennzeichnet, daß der gewundenen Rille (5) eine zweite gewundene Rille (14) gegenüberliegt, die in den Boden (4) des Gefäßes (1) oder in die Unterseite des Metallkörpers (8) eingearbeitet ist und die durch die Membran (12) von der ersten Rille (5) getrennt ist, wobei der von der zweiten Rille (14) und der Membran (12) umschlossene Raum an eine Druckgasleitung angeschlossen ist.

18. Vorrichtung nach Anspruch 1 oder 2, dadurch gekennzeichnet, daß in die Außenwandung des Metallblocks (8) oder in den Boden (4) des Gefäßes (1) mehrere parallel verlaufende Rillen (5') eingearbeitet sind.

## Revendications

1. Dispositif pour enrichir un gaz transporteur ou mélange de gaz transporteurs avec de la vapeur ou des vapeurs d'une substance ou mélange de substances peu volatile(s) sous forme de petites particules solides, constitué par un récipient contenant un corps métallique rigoureusement ajusté enlevable, une rainure enroulée étant ménagée dans au moins une paroi extérieure du corps métallique, laquelle paroi extérieure est en contact avec une paroi intérieure du récipient de façon que la rainure constitue un espace intérieur chauffable pour la réception de la substance ou du mélange de substances, lequel espace intérieur est muni d'une canalisation d'amenée pour le gaz transporteur et d'une canalisation d'évacuation

## EP 0 277 680 B1

pour le gaz transporteur enrichi, les canalisations débouchant dans l'espace intérieur de façon que lors du fonctionnement du dispositif, le gaz transporteur traverse la substance ou le mélange de substances, caractérisé en ce que les parties de la paroi extérieure du corps métallique situées entre les spires séparées de la rainure et mises en contact avec la paroi intérieure du récipient tout en assurant la séparation des spires individuelles de la rainure présentent un profil de section transversale sous forme d'un coin dont le sommet est en contact avec la paroi intérieure du récipient.

2. Variante du dispositif selon la revendication 1, caractérisée en ce que la rainure (5) est réalisée dans le fond (4) du récipient (1), alors que la face inférieure du corps métallique (8) est lisse, les parties (6) du fond du récipient (4) séparant les spires individuelles de la rainure (5) présentant un profil de section transversale sous forme d'un coin dont le sommet est en contact avec la face inférieure du corps métallique (8).

3. Dispositif selon la revendication 1 ou 2, caractérisé en ce que le matériau de la partie présentant la section transversale cunéiforme est plus dur que le matériau de la partie qui est en contact avec le dessus de la partie présentant la section transversale cunéiforme.

4. Dispositif selon la revendication 3, caractérisé en ce que le dessus de la partie présentant la section transversale cunéiforme est recouvert d'un matériau à résistance mécanique élevée.

5. Dispositif selon la revendication 1 ou 2, caractérisé en ce que les flancs du coin enferment un angle compris entre 40° et 140°.

6. Dispositif selon la revendication 5, caractérisé en ce que les flancs du coin enferment un angle compris entre 60° et 90°.

7. Dispositif selon la revendication 5, caractérisé en ce que les deux flancs du coin sont inclinés de façon différente.

8. Dispositif selon la revendication 5, caractérisé en ce que le sommet du coin est arrondi.

9. Dispositif selon la revendication 1 ou 2, caractérisé en ce que la rainure (5) présente une section transversale en V.

10. Dispositif selon la revendication 1 ou 2, caractérisé en ce que la rainure (5) présente une section transversale courbée en forme de sillon.

11. Dispositif selon la revendication 1 ou 2, caractérisé en ce que la rainure (5) présente une section transversale en forme de cuvette.

12. Dispositif selon la revendication 1 ou 2, caractérisé en ce que lors du fonctionnement, le récipient (1) est disposé dans un bain de liquide thermostatique.

13. Dispositif selon la revendication 1 ou 2, caractérisé en ce que la canalisation d'amenée de gaz (2) et la canalisation d'évacuation de gaz (3) présentent des valves ouvert/fermé chauffables.

14. Dispositif selon la revendication 14, caractérisé en ce qu'un filtre de retenue de poudre est chaque fois disposé dans la canalisation d'amenée de gaz (2) après la valve et dans la canalisation d'évacuation de gaz (3) avant la valve.

15. Dispositif selon la revendication 13, caractérisé en ce que le récipient rempli (1) est disposé dans le bain de liquide de façon que le fond (4) du récipient (1) soit parallèle à la direction de la pesanteur, et que lors du fonctionnement du dispositif, le gaz transporteur traverse du haut la substance ou le mélange de substances (7).

16. Dispositif selon la revendication 1 ou 2, caractérisé par une chambre de compression (14) qui est séparée de l'espace intérieur formé par la rainure (5) par une membrane flexible (12).

17. Dispositif selon la revendication 16, caractérisé qu'en face de la rainure enroulée (5) est disposée une deuxième rainure enroulée (14) qui est réalisée dans le fond (4) du récipient (1) ou dans la face inférieure du corps métallique (8) et qui est séparée par la membrane de la première rainure (5), l'espace enfermé par la deuxième rainure (14) et la membrane (12) étant raccordé à une canalisation de gaz comprimé.

18. Dispositif selon la revendication 1 ou 2, caractérisé en ce que dans la paroi extérieure du bloc métallique (8) ou dans le fond (4) du récipient (1) sont réalisées plusieurs rainures parallèles (5').

**Claims**

1. A device for enriching a carrier gas or a mixture of carrier gases with the vapour or vapours of a low-volatility material or mixture of materials which is present in the form of small solid particles, said device comprising a container which has a removable, accurately fitting metal body in at least one outer wall of which a coiled groove is provided and said outer wall is in contact with an inner wall of the container in such a manner that the groove forms a heatable inner space for holding the material or mixture of materials, which body is provided with an inlet duct for the carrier gas and an outlet duct for the enriched carrier gas, the ducts opening into the inner space in such a manner that, during operation of the device, the carrier gas flows through the material or the mixture of materials, characterized in that the parts of the outer wall of the metal body which are present between the individual turns of the groove and which are in contact with the inner wall of the container and which separate the individual turns of the groove from each other have a cross-sectional profile in the form of a wedge, the tip of which is in contact with the inner wall of the container.

2. A modified embodiment of the device as claimed in Claim 1, characterized in that the groove (5) is provided in the bottom (4) of the container (1), while the lower side of the metal body (8) is smooth, the parts (6) of the bottom of the container (4), which separate the individual turns of the groove (5) from each other, having a cross-sectional profile in the form of a wedge, the tip of which is in contact with the lower side of the metal body (8).

3. A device as claimed in Claim 1 or 2, characterized in that the material of the part which has the wedge-shaped cross-section is harder than the material of the part with which the top of the part having the wedge-shaped cross-section is in contact.

4. A device as claimed in Claim 3, characterized in that the top of the part having the wedge-shaped cross-section is covered with a hard material.

5. A device as claimed in Claim 1 or 2, characterized in that the sides of the wedge enclose an angle of between 40° and 140°.

6. A device as claimed in Claim 5, characterized in that the sides of the wedge enclose an angle of between 60° and 90°.

7. A device as claimed in Claim 5, characterized in that the two sides of the wedge are differently inclined.

8. A device as claimed in Claim 5, characterized in that the tip of the wedge is rounded.

9. A device as claimed in Claim 1 or 2, characterized in that the groove (5) has a V-shaped cross-section.

10. A device as claimed in Claim 1 or 2, characterized in that the groove (5) has a duct-shaped vaulted cross-section.

11. A device as claimed in Claim 1 or 2, characterized in that the groove (5) has a trough-shaped cross-section.

12. A device as claimed in Claim 1 or 2, characterized in that, in operation, the container (1) is accommodated in a liquid bath having a thermostat.

13. A device as claimed in Claim 1 or 2, characterized in that heatable open/closed valves are provided at the gas inlet (2) and the gas outlet (3).

14. A device as claimed in Claim 13, characterized in that a powder-retaining filter is provided in the gas inlet (2) behind the valve and in the gas outlet (3) before the valve.

15. A device as claimed in Claim 13, characterized in that the filled container (1) is arranged in the liquid bath in such a manner that the bottom (4) of the container (1) is parallel to the direction of gravity and, during operation, of the device flows through the material or the mixture of materials (7) from the top.

16. A device as claimed in Claim 1 or 2, characterized by a pressure chamber (14) which is separated by a flexible diaphragm (12) from the inner space formed by the groove (5).

17. A device as claimed in Claim 17, characterized in that a second coiled groove (14) is positioned opposite the coiled groove (5) and is formed in the bottom (4) of the container (1) or in the lower side of the metal body (8) and which is separated from the first groove (5) by the diaphragm (12), the space enclosed by the second groove (14) and the diaphragm (12) communicating with a pressure gas duct.

18. A device as claimed in Claim 1 or 2, characterized in that several parallel extending grooves (5') are formed in the outer wall of the metal body (8) or in the bottom (4) of the container (1).

Fig.1

Fig.3

Fig.4

Fig.2a

Fig.2b

Fig.2c

Fig.2d